# EUROPÄISCHE PATENTSCHRIFT

(11) **EP 2 380 028 B1**
(45) Veröffentlichungstag und Bekanntmachung des Hinweises auf die Patenterteilung: **26.06.2013**
(21) Anmeldenummer: 09771523.9
(22) Anmeldetag: 24.11.2009
(51) Int. Cl.: H02P 29/02

(54) **VERFAHREN ZUR ÜBERWACHUNG EINER ANSTEUEREINRICHTUNG EINES 3-STRÄNGIGEN ELEKTROMOTORS UND/ODER DES ELEKTROMOTORS**
METHOD FOR MONITORING A CONTROLLER OF A THREE-PHASE ELECTRIC MOTOR AND/OR THE ELECTRIC MOTOR
PROCÉDÉ POUR CONTRÔLER UN DISPOSITIF DE COMMANDE D'UN MOTEUR ÉLECTRIQUE TRIPHASÉ ET/OU LE MOTEUR ÉLECTRIQUE

(30) Priorität: 19.12.2008 DE 102008055012
(43) Veröffentlichungstag der Anmeldung: 26.10.2011
(73) Patentinhaber: BSH Bosch und Siemens Hausgeräte GmbH, 81739 München (DE)
(72) Erfinder: ABEL, Falko, 93089 Aufhausen (DE); HOCHHAUSEN, Ralf, 93138 Lappersdorf (DE)
(86) Internationale Anmeldenummer: PCT/EP2009/065755
(87) Internationale Veröffentlichungsnummer: WO 2010/069722

(56) Entgegenhaltungen:
- GB-A- 2 404 100
- JP-A- 63 202 285
- JP-A- 2005 312 201
- JP-A- 2006 184 160
- JP-A- 2007 089 261
- US-A1- 2003 222 612
- US-A1- 2005 099 743

## Beschreibung

Die Erfindung betrifft ein Verfahren zur Überwachung einer Ansteuereinrichtung zur Ansteuerung eines 3-strängigen Elektromotors und/oder zur Überwachung des Elektromotors, insbesondere eines Asynchron- oder Synchronmotors.

Es ist bekannt, in Geschirrspülern Laugenpumpen mit einsträngigen Spaltpolmotoren einzusetzen. Diese Motoren sind für einen diskreten Arbeitspunkt ausgelegt und werden direkt an eine elektrische Netzspannung gelegt. Der Verlust der einzigen Phase führt zum Stillstand und kann über den nicht vorhandenen Strangstrom sofort erkannt werden. Das Erkennen von Fehlfunktionen in den Strängen ist z.B. Gegenstand der Dokumente JP 2007089261, JP 2006184160, JP 2005312201, US 2003222612 und US 2005099743.

Der Erfindung liegt die Aufgabe zugrunde, ein Verfahren anzugeben, mit dem eine Funktionsprüfung einer Ansteuereinrichtung zur Ansteuerung eines Elektromotors und/oder zur Funktionsprüfung des Elektromotors, insbesondere eines Haushaltsgeräts, durchgeführt werden kann. Insbesondere soll ein Elektromotor zum Einsatz kommen, der gegenüber dem erwähnten Spaltpolmotor vielseitigere Eigenschaften besitzt.

Diese Aufgabe wird erfindungsgemäß durch die Verfahrenschritte des Anspruchs 1 gelöst.

Bei dem hier beschriebenen System werden die gemessenen Ströme hinsichtlich einer möglichen Fehlerkombination daraufhin untersucht, ob wenigstens einer der gemessenen Ströme Null ist und die anderen nicht und/oder die Summe der gemessenen Ströme im Wesentlichen Null ist. Ist wenigstens einer der Bedingungen erfüllt, so erfolgt die Ausgabe eines Fehlersignals, das anzeigt, dass die Ansteuereinrichtung und/oder der Elektromotor nicht ordnungsgemäß arbeitet/arbeiten.

Hierzu ist anzumerken, dass beim Fehlen einer Phase der Strangstrom in der fehlenden Phase Null ist und in den beiden anderen Phasen entgegensetzt gleichgroß (Phasenopposition). Da die beiden Strangströme Sinusströme sind, die jeweils alle 180° einen Wert von Null aufweisen und da auch die dreisträngigen Ströme jeweils alle 180° den Wert Null besitzen, muss bei dem erfindungsgemäßen Vorgehen berücksichtigt werden, dass das "Null sein" für einen gewissen Zeitraum zulässig ist und keine Aussage auf Funktionsfähigkeit zulässt. Auch ist die erwähnte Strommessung der Strangströme einer Toleranz unterworfen, sodass vorzugsweise Grenzen (erstes Toleranzband) definiert werden, innerhalb derer ein Strangstrom als Null angenommen wird. Ebenfalls werden Grenzen (zweites Toleranzband) vorgegeben, innerhalb derer die Differenz zweier Strangströme liegen muss, um die beiden Strangströme als einander entgegengesetzt zu identifizieren. Es ist bei dem erfindungsgemäßen Vorgehen stets ausreichend, nur zwei der drei Strangströme zu messen, da die drei Stränge des Synchronmotors im Stern verschaltet sind. Da der Summenstrom des Knotenpunkts der Sternschaltung Null ist, kann aus den beiden gemessenen Strangströmen das gesamte dreiphasige System erfasst werden, es kann also der fehlende Strangstrom beziehungsweise Phasenstrom ermittelt werden. Fehlt eine Phase, so muss unterschieden werden, ob im zugehörigen Strang eine von zwei Strommessvorrichtungen positioniert ist, die die Strommessungen vornehmen, oder ob es sich um den Strang handelt, dem keine Strommessvorrichtung zugeordnet ist.

Vorzugsweise wird ein zweiter Zähler inkrementiert, wenn der erste Zähler innerhalb eines definierten Zeitraums mehrfach einen ersten Grenzwert, der vorgebbar ist, überschreitet. Dadurch lassen sich Unregelmäßigkeiten zuverlässiger erkennen als z.B. in US 2005099743, WO einem Strang nur ein einziger Zähler zugeordnet ist. Vorzugsweise wird auf einen Verlust mindestens eines Strangstromes, also auf den Ausfall mindestens einer Phase des Asynchron- oder Synchronmotors, dann erkannt, wenn der zweite Zähler einen zweiten, insbesondere vorgebbaren Grenzwert überschreitet. Durch dieses Vorgehen ist eine hohe Zuverlässigkeit bei der Erkennung des Verlustes mindestens einer Phase des Synchronmotors gegeben.

Insbesondere kann der zweite Zähler inkrementiert und ein Timer gestartet werden, wenn der erste Zähler den ersten Grenzwert überschreitet. Der erste Zähler wird vorzugsweise zurückgesetzt, wenn er den ersten Grenzwert überschreitet. Der zweite Zähler wird insbesondere weiter inkrementiert, wenn innerhalb des definierten Zeitraums der erste Zähler mindestens ein weiteres Mal den ersten Grenzwert überschreitet. Je nach Aussagezuverlässigkeit kann vorgesehen sein, dass der erste Zähler nicht nur ein weiteres Mal, sondern mehr als zweimal den ersten Grenzwert überschreiten muss. Bei dem erwähnten, definierten Zeitraum handelt es sich insbesondere um eine vorgebbare Timerzeit des erwähnten Timers.

Ferner betrifft die Erfindung eine Vorrichtung zur Funktionsüberwachung eines Elektromotors eines Haushaltgeräts, insbesondere zur Durchführung des vorstehend erwähnten Verfahrens, wobei der Elektromotor als ein in Stern geschalteter, dreisträngiger, dreiphasiger, permanenterregter Synchronmotor ausgebildet und mit einer feldorientierten Vektorregelung versehen ist, und mittels einer Messeinrichtung zwei Strangströme gemessen und die Messergebnisse mittels einer Detektorschaltung zur Überwachung der Drehzahl des Synchronmotors und/oder zur Überwachung auf ein Vorhandensein aller Strangströme in den Strängen des Synchronmotors ausgewertet werden.

Ferner betrifft die Erfindung ein Haushaltsgerät, insbesondere einen Geschirrspüler oder eine Wachmaschine, wobei das Haushaltsgerät mit einer Vorrichtung der vorstehenden Art versehen ist.

Die Zeichnungen verdeutlichen die Erfindung und zwar zeigt:
- Figur 1: ein Strukturbild, das eine Funktionsüberwachung des Synchronmotors erlaubt und
- Figur 2: ein Reglerersatzschaltbild einer Vektorregelung für einen dreiphasigen, permanenterregten Synchronmotor.

Die Erfindung geht von einem dreisträngigen, dreiphasigen, permanenterregten Synchronmotor eines Haushaltgeräts, insbesondere einer Geschirrspülmaschine oder einer Waschmaschine, aus, wobei der Synchronmotor beispielsweise eine Pumpe des Haushaltsgeräts antreibt, die als Laugenpumpe und/oder Umwälzpumpe dient.

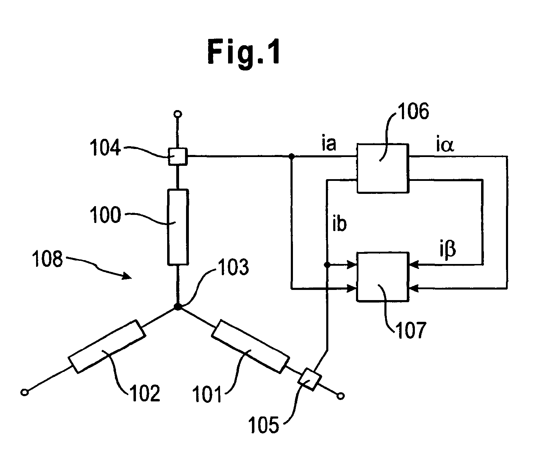

Die Figur 1 verdeutlicht drei Stränge 100, 101 und 102 eines dreisträngigen, dreiphasigen, permanenterregten Synchronmotors 108, wobei die drei Stränge 100 bis 102 in einem Sternpunkt 103 zusammengeschaltet sind. Den Strängen 100 und 101 ist jeweils eine Strommessvorrichtung 104, 105 zugeordnet, die die zugehörigen Strangströme ia und ib messen. Die Strangströme ia und ib werden mittels einer Einrichtung 106 in Komponentenströme iα, iβ überführt, insbesondere transformiert. Die beiden Strangströme ia, ib und/oder die beiden Komponentenströme iα, iβ werden einer Detektorschaltung 107 zugeführt, die eine Überwachung der Drehzahl n des Synchronmotors 108 und/oder eine Überwachung auf Vorhandensein aller drei Strangströme in den drei Strängen 100, 101, 102 des Synchronmotors 108 vornimmt. Da der Summenstrom im Sternpunkt 103 Null ist, reicht es aus, nur in den beiden Strängen 100 und 101 die Strangströme ia und ib zu messen. Der Strangstrom im Strang 102 lässt sich dann berechnen. Zur Sprachregelung sei noch angemerkt, dass von "Strängen" gesprochen wird, wenn es sich um das physikalische Wirkungssystem handelt und um "Phasen", wenn es um die Generierung eines Spannungssystems geht.

Die Ansteuerung des Synchronmotors 108 erfolgt mit einer sogenannten feldorientierten Vektorregelung. Hierzu werden die beiden Strangströme ia und ib verwendet, um unter Berücksichtigung eines Motormodells des Synchronmotors 108 diesen mit einem dreiphasigen, pulsweitenmodulierte Spannungssystem ansteuern zu können. Dieses Spannungssystem lässt sich in der Frequenz, der Phasenlage und der Amplitude einstellen. Die Speisung des Synchronmotors 108 erfolgt demzufolge mit einem sogenannten Modulator.

Die Strangströme ia, ib, die auch als Phasenströme bezeichnet werden können, werden - wie erwähnt - mit Hilfe der beiden Strommessvorrichtungen 104 und 105 gemessen. Die beiden Strommessvorrichtungen 104 und 105 weisen jeweils einen Shuntwiderstand auf, wobei der an dem jeweiligen Shuntwiderstand auftretende Spannungsabfall direkt proportional zu dem zugehörigen Strangstrom ia beziehungsweise ib ist.

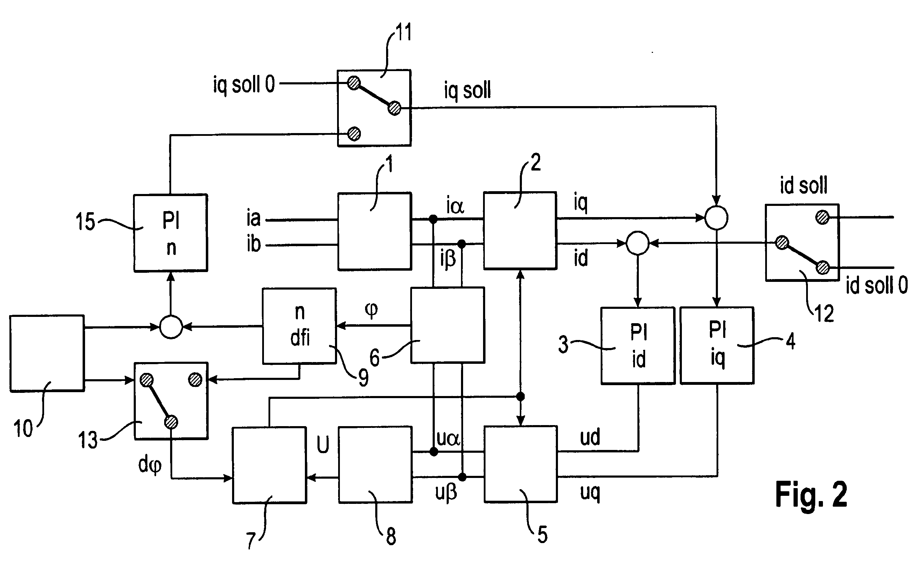

Die Figur 2 verdeutlicht den Regelkreis zur feldorientierten Vektorregelung mit Hilfe eines Reglerersatzschaltbilds. Aus dem dreisträngigen, um 120° versetzte Ströme aufweisenden Stromsystem werden die beiden Strangsströme ia, ib gemessen. Dies erfolgt mit den Strommessvorrichtung 104, 105 gemäß Figur 1. Mit Hilfe einer mit Bezugszeichen 1 angedeuteten Clark-Transformation (Einrichtung 106 in Figur 1) werden die zwei reellen, um 120° versetzten Strangströme ia, ib in ein komplexes, statororientiertes, orthogonales Koordinatensystem überführt, das heißt, es liegt jetzt ein zweisträngiges 90°-System vor, das die Komponentenströme iα und iβ umfasst. Diese beiden Komponentenströme iα und iβ werden mit Hilfe einer mit 2 bezeichneten Park-Transformation über den Rotorwinkel ϕ ins Rotorkoordinatensystem gedreht. Hieraus resultieren die gedrehten Stromkomponenten id und iq, wobei id dem Magnetisierungsstrom und iq dem Drehmoment bildenden Strom des Synchronmotors entsprechen. Diese Stromkomponenten id und iq werden in nachgeschalteten PI-Reglerstufen 3 und 4 auf unterschiedliche Sollwerte id soll und iq soll geregelt. Anschließend erfolgt eine inverse Transformation, die mit dem Bezugszeichen 5 gekennzeichnet ist und die neben den Komponentenspannungen uα und uβ für ein Motormodell 6 auch Amplituden für einen Modulator 7 liefern. Bei dem Modulator 7 handelt es sich um ein Element, das in der Lage ist, ein dreiphasiges, pulsweitenmoduliertes Spannungssystem zu erzeugen, welches in Frequenz, Phasenlage und Amplitude einstellbar ist. Ein derartiger Modulator 7 wird auch als Umrichter bezeichnet. Für die Bereitstellung der Amplituden der Komponentenspannungen uα und uβ ist eingangsseitig des Modulators 7 ein Absolutwertbildner 8 vorgesehen. Der bereits erwähnte Rotorwinkel ϕ (Polradwinkel) wird nicht direkt an dem Synchronmotor 108 gemessen, sondern mit Hilfe des Motormodells 6 aus den Komponentenströmen iα und iβ und den Komponentenspannungen uα und uβ berechnet. Das Motormodell 6 bildet den Synchronmotor 108 nach. Aus der zeitlichen Differenzierung des Rotorwinkels wird die Drehzahl n berechnet. Dies ist mit dem Bezugszeichen 9 angedeutet. Aus der Drehzahl n wird unter Kenntnis von diskreten Modulationsschrittzeiten ein aktueller Winkelschritt für den Modulator 7 berechnet. Da im Anlaufzeitpunkt des Synchronmotors 108 keinerlei Strom- und Drehzahlinformationen zur Verfügung stehen, wird der Synchronmotor 108 gesteuert angefahren. Hierzu ist ein mit 10 bezeichnetes Rampenmodell vorgesehen, dass nach Vorgabe einer Anfangsrampensteilheit eine aktuelle Zieldrehzahl und einen aktuellen Winkelschritt generiert. Die Sollwerte für die beiden Stromkomponenten id und iq werden fest vorgegeben. Die Figur 2 enthält drei Schalter 11, 12 und 13, die dort jeweils eine Stellung einnehmen, wie sie für den Anlauf des Synchronmotors 108 erforderlich ist. Ist der Synchronmotor 108 angelaufen, so werden sie umgeschaltet. Beim Anlauf durchläuft der Modulator 7 eine Sinustabelle zur Generierung eines Ausgangsspannungsmusters mit dem Winkelinkrement der Rampe des Rampenmodells 10 und der Amplitude aus den Stromreglerkreisen der Anlaufsollwerte. Wird eine festgelegte Drehzahl n erreicht, bei welcher die Strangströme ia, ib sicher gemessen und das Motormodell 6 sicher berechnet werden können, so wird vom gesteuerten in den geregelten Betrieb umgeschaltet, das heißt, die Schalter 11 bis 13 werden umgelegt und es ergibt sich ein Synchronisationspunkt. Ein Drehzahlregler 15, der als PI-Regler ausgebildet ist, berechnet nun nach Vorgabe einer vorliegenden Drehzahlabweichung einen Sollwert iq soll für die Drehmoment bildende Stromkomponente iq. Die magnetisierende Stromkomponente id wird auf Null geregelt.

Im Hinblick auf die Messung der Strangströme iα und iβ ist anzumerken, dass diese mit Hilfe von den zwei Shuntwiderständen der Strommessvorrichtungen 104, 105 in den Fußpunkten der Motorwicklungen des Synchronmotors 108 gemessen werden. Beim Modulator 7 ist insbesondere eine Halbbrückenschaltung vorgesehen. Die Spannungsabfälle an den beiden Shuntwiderständen werden mit Hilfe von zwei schnellen Verstärkerschaltungen an einen Spannungsmessbereich eines Mikrocontrollers von 0 V bis 5 V angepasst. Die Verstärkerschaltungen sind identisch aufgebaut und so dimensioniert, dass eine Strommessung im Raster einer Pulsweitenmodulation ohne Verzerrung möglich ist. Da in den beiden Fußpunkten positive und negative Ströme gleicher Amplitude gemessen werden müssen, besitzen die Verstärkerschaltungen jeweils eine Offsetspannung, welche sich in der Mitte des möglichen Aussteuerbereichs befindet. Die jeweilige Offsetspannung wird bei Motorstillstand ständig gemessen und auf Plausibilität überprüft. Um den Einfluss von Störungen zu minimieren, werden die Offsetspannungen durch SW-Tiefpässe gefiltert. Im Falle einer unplausiblen Offsetspannung nimmt eine Umrichtersoftware einen Fehlerzustand ein, in dem eine Ansteuerung der Pumpe nicht möglich ist.

Eine Abtastung der Strangströme ia und ib erfolgt interruptgesteuert und wird mit Pulsweitenmodulationsfrequenz eines Pulsweitenmodulators des Umrichters durchgeführt. Der Abtastzeitpunkt liegt in der Mitte der Ansteuerung von drei Lowside-Leistungshalbleitern des Umrichters. Zu diesem Zeitpunkt werden die drei Motorwicklungen des Synchronmotors 108 über die Leistungshalbleiter kurzgeschlossen und es kann ein Freilaufstrom der Motorwicklungen gemessen werden. Da die Triggerung der Abtastung genau in der Mitte der Impulse liegt, wird der Einfluss von Störungen aufgrund von Pulsweitenmodulations-Schaltflanken minimiert. Während eines Pulsweitenmodulations-Zyklusses wird immer nur ein Strom abgetastet. Die beiden Ströme werden zeitversetzt um die Pulsweitenmodulations-Zykluszeit vor der Berechnung des Motormodells gemessen. Hierbei wird vorausgesetzt, dass der Strom in den Phasen des Synchronmotors während einer Pulsweitenmodulations-Zykluszeit konstant ist. Die Pulsweitenmodulations-Frequenz wird so gewählt, dass diese Bedingung erfüllt ist. Die Erfassung der Ströme erfolgt mit einer Analog-Digital-Wandler-Auflösung von 10 Bit. Mit dieser Auflösung wird der Spitze zu Spitze-Wert der Phasenströme abgebildet.

Eine Modulation von Ausgangsspannungen des Umrichters ist nach einem Lookuptable (LUT)-Verfahren implementiert. Der aktuelle Winkel der Ausgangsspannung wird in einem Phasenakkumulator (16 Bit) gespeichert und zyklisch alle 600 µs durch einen Regelalgorithmus korrigiert. Zwischen den Korrekturen wird ein Modulationswinkel mit einer konstanten Winkelgeschwindigkeit weitergefahren. Die LUT besitzt eine Auflösung von 16 Bit und ist mit 256 Stützstellen in einem Flash eines Controllers hinterlegt. Ein Update der Pulsweitenmodulations-Werte erfolgt bei jedem zweiten Pulsweitenmodulations-Zyklus. Die Ausgabespannungen werden mit Hilfe einer Zwischenkreisspannung des Umrichters bei jeder Modulationswertberechnung korrigiert. Damit kann ein Einfluss eines Spannungs-Ripples im Zwischenkreis des Umrichters weitgehend kompensiert werden.

Wie vorstehend erwähnt, erfolgt ein Transformationsschritt bei der genannten feldorientierten Vektorregelung, um die Strangströme ia und ib in die Komponentenströme iα und iβ zu überführen. Dieser Transformationsschritt ist rein algebraisch und enthält keinerlei Modelle. Wie erwähnt, beschreiben die Komponentenströme iα und iβ das dreiphasige Stromsystem in orthogonaler Darstellung. Aus den beiden Komponentenströmen iα und iβ wird ein Winkel mit Statorbezug berechnet. Die Messung wird in zeitlich definierten Abständen wiederholt. Die Abstände werden vorzugsweise derart gewählt, dass sie den Anforderungen einer Fehlererkennung genügen. Aus den laufenden Messungen wird durch Differenzierung des Winkels nach der Zeit eine Winkelgeschwindigkeit und in Folge daraus eine Drehzahl n des Synchronmotors 108 berechnet. Vorzugsweise wird die Winkeldifferenz benachbarter Winkel und die Zeitdifferenz benachbarter Zeiten gebildet und für die Differenzierung die Winkeldifferenz durch die Zeitdifferenz geteilt.

Da Stromsamples verworfen werden können, sich somit die zeitliche Zugehörigkeit zweier Stromsamples für ia und ib ändern kann und die Messung im unteren Drehzahlbereich ungenauer ist, kann die Drehzahl vorzugsweise gefiltert werden. Alternativ zum Filtern ist es vorteilhaft, ein Auswahlkriterium anzuwenden. Sofern y-Werte von x-Werten einer Vorgabe entsprechen, wird von der Richtigkeit des Ergebnisses ausgegangen.

Wie bereits erwähnt, sind die drei Stränge 100 bis 102 des Synchronmotors 108 in Stern verschaltet. Da der Summenstrom eines Knotenpunkts Null ist, reicht es somit aus, zwei der drei Stränge zu messen. Dies wurde anhand der Figur 1 bereits erläutert. Beim Fehlen einer Phase, wenn also ein Phasenstrom einer Phase ausfällt, muss unterschieden werden, ob in dieser Phase eine der beiden Strommessungen positioniert ist oder ob es sich um die nicht gemessene Phase handelt. Es ist also zu prüfen, ob in dieser Phase eine der beiden Strommessvorrichtungen 104, 105 liegt oder nicht.

Beim Fehlen einer Phase ist der Strom in der fehlenden Phase, also in dem betreffenden Strang, Null und in den beiden anderen Phasen/Strängen entgegengesetzt gleich groß. Es liegt die so genannte Phasenopposition vor. Da die beiden Phasenströme ia, ib alle 180° jeweils Null sind (Sinusströme) und auch die dreisträngigen Ströme jeweils alle 180° Null sind, muss bei der Messung auf Nullstrom berücksichtig werden, dass dies für einen gewissen Zeitraum zulässig ist. Die Strommessungen mittels der Strommesseinrichtungen 104 und 105 unterliegen jeweils einer Toleranz, sodass gewisse Grenzen definiert werden müssen, innerhalb derer ein Strom als Null angenommen wird. Ebenfalls werden Grenzen benötigt, innerhalb derer die Differenz zweier Ströme liegen kann, um die beiden Ströme als einander entgegengesetzt zu identifizieren. Im ersten Fall wird ein erstes Toleranzband als Grenzen definiert und für den zweiten Fall ein zweites Toleranzband. Für die Überwachung der Vollständigkeit der Stränge des Synchronmotors 108, ob also der Ausfall mindestens einer Phase des Synchronmotors 108 vorliegt, werden die beiden gemessenen Ströme ia und ib hinsichtlich folgender möglicher Fehlerkombinationen untersucht: a) wenn einer der beiden gemessenen Strangströme ia, ib innerhalb des ersten Toleranzbandes liegt, wird dieser Strangstrom zu Null angenommen, b) wenn die Differenz der beiden gemessenen Strangströme ia, ib innerhalb des zweiten Toleranzbandes liegt, werden die beiden gemessenen Strangströme als zueinander entgegengesetzt in Phasenopposition angenommen.

Im Schritt a) wird untersucht, ob einer der beiden Ströme ia, ib unterhalb der durch das erste Toleranzband gebildeten Nullstromgrenze liegt. Im Schritt b) wird untersucht, ob die Differenz der gemessenen Ströme ia, ib unterhalb der durch das zweite Toleranzband definierten Phasenoppositionsgrenze liegt.

Grundsätzlich ist anzumerken, dass es prinzipbedingt einfacher ist, einen Nullstrom zu detektieren, als eine Phasenopposition. Tritt eines der beiden erwähnten Ereignisse auf, so wird ein erster Zähler inkrementiert, insbesondere je nach Art des Ereignisses gewichtet erhöht. Sowie eine Messung weder das eine noch das andere Kriterium erfüllt, wird der erste Zähler zurückgesetzt.

Überschreitet dieser erste Zähler einen ersten Grenzwert, so wird ein zweiter Zähler inkrementiert und der erste Zähler wird zurückgesetzt sowie ein Timer gestartet. Tritt innerhalb eines definierten Zeitraums, insbesondere der vorgegebenen Timerzeit, ein zweites Mal beziehungsweise mindestens ein zweites Mal das Überschreiten des ersten Grenzwertes des ersten Zählers auf, wird der zweite Zähler weiter inkrementiert. Tritt dieser Fall nicht auf, wird der zweite Zähler zurückgesetzt. Überschreitet der zweite Zähler einen zweiten Grenzwert, so wird auf Verlust einer Phase, also auf nicht Vorhandensein eines Strangstromes in einem Strang 100, 101, 102 erkannt.

Zusammenfassend lässt sich für das Vorgehen bei der Drehzahlerkennung anmerken, dass hierzu die Komponentenströme iα und iβ eines Transformationsschrittes der feldorientierten Vektorregelung ohne irgendwelche Modellbildung verwendet werden. Die Berechnung von statororientierten Winkeln erfolgt stets zu mindestens zwei definierten Zeitpunkten, wobei die zeitliche Differenz nur die Genauigkeitsanforderungen an die Stillstandserkennung genügen muss (unter Berücksichtigung des sich anschließenden Filters/der sich anschließenden Auswertung). Es folgt die Berechnung der Drehzahl (genäherte Drehzahl) aus der zeitlichen Differenzierung des Winkels. Ferner wird eine Gewichtung der Drehzahlinformation (insbesondere y aus x Drehzahlwerten innerhalb einer Toleranz) vorgenommen.

Bei der Prüfung auf Vollständigkeit der Stränge erfolgt die Messung zweier Strangströme des in Stern geschalteten Synchronmotors. Es wird eine gewichtete Erhöhung eines ersten Zählers vorgenommen, wenn entweder ein Strom unterhalb einer Nullstromgrenze liegt oder die Differenz zweier Ströme innerhalb einer Phasenoppositionsgrenze. Ein zweiter Zähler wird erhöht, wenn der erste Zähler innerhalb eines definierten Zeitraums mehrfach einen (ersten) Grenzwert des ersten, gewichteten Zählers überschreitet. Es erfolgt die Erkennung des Verlustes einer Phase, wenn der zweite Zähler einen ihm zugeordneten (zweiten) Grenzwert überschreitet.

## Patentansprüche

1. Verfahren zur Überwachung einer Ansteuereinrichtung zur Ansteuerung eines 3-strängigen Elektromotors und/oder zur Überwachung des Elektromotors, insbesondere eines Asynchron- oder Synchronmotors, wenigstens umfassend die folgenden Schritte:
- Messen von 2 Strangströmen (ia, ib),
- Überprüfen, ob einer der 2 gemessenen Strangströme (ia, ib) im Wesentlichen Null ist,
- Erzeugen eines Fehlersignals, wenn wenigstens einer der 2 gemessenen Strangströme (ia, ib) im Wesentlichen Null ist,
- Überprüfen, ob die 2 gemessenen Strangströme (ia, ib) im Wesentlichen ungleich Null sind,
- Bilden der Summe der 2 gemessenen Strangströme (ia, ib), und
- Erzeugen eines Fehlersignals, wenn die gebildete Summe der 2 gemessenen Strangströme (ia, ib) im Wesentlichen Null ist, wobei
- beim Auftreten eines Fehlersignals ein erster Zähler inkrementiert wird,
- ein zweiter Zähler inkrementiert wird, wenn der erste Zähler innerhalb eines definierten Zeitraums mehrfach einen ersten Grenzwert des ersten Zählers überschreitet, und
- ein Verlust mindestens eines Strangstromes der drei Strangströme erkannt wird, wenn der zweite Zähler einen zweiten Grenzwert überschreitet.

2. Verfahren nach Anspruch 1, **dadurch gekennzeichnet, dass** der zweite Zähler inkrementiert und ein Timer gestartet wird, wenn der erste Zähler den ersten Grenzwert überschreitet.

3. Verfahren nach Anspruch 1 oder 2, **dadurch gekennzeichnet, dass** der erste Zähler zurückgesetzt wird, wenn er den ersten Grenzwert überschreitet.

4. Verfahren nach einem der vorhergehenden Ansprüche 1 bis 3, **dadurch gekennzeichnet, dass** der zweite Zähler weiter inkrementiert wird, wenn innerhalb des definierten Zeitraums der erste Zähler mindestens ein weiteres Mal den ersten Grenzwert überschreitet.

5. Verfahren nach Anspruch 4, **dadurch gekennzeichnet, dass** der definierte Zeitraum eine vorgebbare Timerzeit des Timers ist.

6. Verfahren nach einem der vorhergehenden Ansprüche, **dadurch gekennzeichnet, dass** der Elektromotor für den Betrieb eines Haushaltsgeräts, insbesondere eines Geschirrspülers oder einer Waschmaschine, verwendet wird.

7. Haushaltgerät, insbesondere Geschirrspüler oder Waschmaschine, wenigstens aufweisend einen Elektromotor und eine Vorrichtung zur Überwachung des Elektromotors gemäß dem Verfahren nach einem oder mehreren der vorhergehenden Ansprüche.

## Claims

1. Method for monitoring a controller for controlling a 3-phase electric motor and/or for monitoring the electric motor, especially an asynchronous or synchronous motor, at least comprising the following steps:
- Measuring 2 phase currents (ia, ib),
- Checking whether one of the 2 measured phase currents (ia, ib) is essentially zero,
- Generating an error signal if at least one of the 2 measured phase currents (ia, ib) is essentially zero,
- Checking whether the 2 measured phase currents (ia, ib) are essentially not equal to zero,
- Forming the sum of the 2 measured phase currents (ia, ib), and
- Generating an error signal if the sum formed of the 2 measured phase currents (ia, ib) is essentially zero, wherein
- a first counter is incremented if an error signal occurs,
- a second counter is incremented if the first counter exceeds a first threshold of the first counter a number of times within a defined period, and
- a loss of at least one phase current of the three phase currents is detected if the second counter exceeds a second threshold.

2. Method according to claim 1, **characterised in that** the second counter is incremented and a timer is started if the first counter exceeds the first threshold.

3. Method according to claim 1 or 2, **characterised in that** the first counter is reset if it exceeds the first threshold.

4. Method according to one of the preceding claims 1 to 3, **characterised in that** the second counter is further incremented if, within the defined period of time, the first counter exceeds the first threshold at least one further time.

5. Method according to claim 4, **characterised in that** the defined period of time is a specifiable timer time of the timer.

6. Method according to one of the preceding claims, **characterised in that** the electric motor is used to operate a household appliance, especially a dishwasher or a washing machine.

7. Household appliance, especially a dishwasher or a washing machine, at least having an electric motor and a facility for monitoring the electric motor in accordance with the method according to one or more of the preceding claims.

## Revendications

1. Procédé pour contrôler un dispositif de commande d'un moteur électrique triphasé et/ou pour contrôler le moteur électrique, en particulier un moteur asynchrone ou synchrone, comprenant au moins les étapes suivantes :
- mesurer deux courants de phase (ia, ib),
- contrôler si un des deux courants de phase (ia, ib) mesurés est sensiblement nul,
- générer un signal d'erreur si au moins un des deux courants de phase (ia, ib) mesurés est sensiblement nul,
- contrôler si les deux courants de phase (ia, ib) mesurés sont sensiblement non nuls,
- établir la somme des deux courants de phase (ia, ib) mesurés, et
- générer un signal d'erreur si la somme établie des deux courants de phase (ia, ib) est sensiblement nulle, procédé dans lequel
- un premier compteur est incrémenté lorsqu'apparaît un signal d'erreur,
- un deuxième compteur est incrémenté si le premier compteur dépasse une première valeur limite du premier compteur à plusieurs reprises pendant un intervalle défini, et
- une perte d'au moins un courant de phase des trois courants de phase est détectée si le deuxième compteur dépasse une deuxième valeur limite.

2. Procédé selon la revendication 1, **caractérisé en ce que** le deuxième compteur est incrémenté et un minuteur est démarré si le premier compteur dépasse la première valeur limite.

3. Procédé selon la revendication 1 ou 2, **caractérisé en ce que** le premier compteur est remis à zéro s'il dépasse la première valeur limite.

4. Procédé selon l'une des revendications précédentes 1 à 3, **caractérisé en ce que** le deuxième compteur continue d'être incrémenté si le premier compteur dépasse la première valeur limite au moins une autre fois pendant l'intervalle défini.

5. Procédé selon la revendication 4, **caractérisé en ce que** l'intervalle défini est un temps prédéfinissable du minuteur.

6. Procédé selon l'une des revendications précédentes, **caractérisé en ce que** le moteur électrique est utilisé pour faire fonctionner un appareil ménager, en particulier un lave-vaisselle ou un lave-linge.

7. Appareil ménager, en particulier lave-vaisselle ou lave-linge, comprenant au moins un moteur électrique et un dispositif pour contrôler le moteur électrique conformément au procédé selon l'une ou plusieurs des revendications précédentes.
